# EUROPÄISCHE PATENTSCHRIFT

(11) **EP 0 319 677 B1**
(45) Veröffentlichungstag und Bekanntmachung des Hinweises auf die Patenterteilung: **16.03.1994**
(21) Anmeldenummer: 88117130.0
(22) Anmeldetag: 14.10.1988
(51) Int. Cl.: G11C 27/02

(54) **Abtast- und Halteschaltung für Fernmeldeanlagen**
Sample and hold circuit for telecommunication systems
Circuit d'échantillonnage et de maintien pour systèmes de télécommunications

(30) Priorität: 11.12.1987 DE 3742115
(43) Veröffentlichungstag der Anmeldung: 14.06.1989
(73) Patentinhaber: SIEMENS AKTIENGESELLSCHAFT, 80333 München (DE)
(72) Erfinder: Haass, Adolf, D-8000 München 60 (DE)

(56) Entgegenhaltungen:
- GB-A- 1 215 912
- PATENT ABSTRACTS OF JAPAN, Band 10, Nr. 127 (P-455), 13. Mai 1986;& JP-A-60 251 600
- PATENT ABSTRACTS OF JAPAN, Band 10, Nr. 149 (P-461), 30. Mai 1986;& JP-A-61 000 998

## Beschreibung

Die Erfindung betrifft eine Abtast- und Halteschaltung mit einem zwischen einem Eingangsanschluß und einem Kondensator liegenden Abtastkreis, der durch ihm zugeführte Abtastimpulse den Kondensator nach Maßgabe eines am Eingangsanschluß jeweils vorhandenen Eingangssignals aufzuladen gestattet und mit einem Ausgangskreis, der zwischen dem Kondensator und einem Ausgangsanschluß vorgesehen ist, von welchem ein der auf dem Kondensator jeweils gespeicherten Siganlspannung entsprechendes Ausgangssignal abgebbar ist.

Abtast- und Halteschaltungen sind bereits vielfältig bekannt. Hierzu sei auf die Aufsätze von Walter Jung "Sample- and - Hold-Verstärker in der Praxis", erster Teil und zweiter Teil in der Zeitschrift "Elektronik" Nr. 13, Seiten 106 bis 112 (erster Teil) und Nr. 14, Seiten 65 bis 70 (zweiter Teil) hingewiesen. Ferner seien das Fachbuch "Field-Effect Transistors" von Leonce J. Seven, Jr., herausgegeben von der Mc Graw-Hill Book Company New York /SanFrancisco /Toronto / London/Sydney, Copyright, 1965 und insbesondere auf die dortigen Seiten 113 und 114 erwähnt.

Abtast- und Halteschaltungen der bekannten Art sind aus Transistoren und R-C-Elementen aufgebaut. Ihre Arbeitsweise wird als bekannt vorausgesetzt. Für solche Abtast- und Halteschaltungen kann die Forderung bestehen, daß sie für einen großen Geschwindigkeitsbereich einsetzbar sein müssen, z.B. für Abtast-Raten entsprechend einem Abtastfrequenzbereich zwischen 1 und 500 kHz. Hieraus resultiert das Problem, daß ein in Abtast- und Halteschaltungen der von der Erfindung vorausgesetzten Art enthaltener Ladekondensator einerseits bei der höchsten vorkommenden Abtastfrequenz relativ schnell aufgeladen werden muß, daß sich dieser Kondensator aber bei einem Betrieb mit der niedrigsten vorkommenden Abtastfrequenz immer nur sehr langsam entladen darf. In entsprechenden bekannten Schaltungsansordungen wurden deshalb zur Ladung des genannten Kondensators relativ hochwertige und entsprechend aufwendige Bauteile eingesetzt, um auf diese Weise auch bei den höchsten vorkommenden Abtastfrequenzen die erforderliche Ladung des Kondensators zu gewährleisten. Trotz dieses besonderen Aufwandes erwies es sich in bekannten Fällen als problematisch oder sogar als nicht möglich, die jeweils geforderte hohe Abtastrate zu erreichen. Eine Abtast- und Halteschaltung dieser Art, gemäß Präambel des Anspruch 1, ist aus der japanischen Patentanmeludung JP-A-61 000 998 bekannt.

Für die Erfindung besteht die Aufgabe, eine Schaltungsanordnung der eingangs angegebenen Art so auszubilden, daß sich mit relativ einfachen Mitteln einerseits bei höchster Abtastfrequenz die erforderliche Aufladung des Ladekondensators mit Sicherheit erzielen läßt, andererseits aber dieser Kondensator bei niedrigster Abtastfrequenz jeweils nur sehr langsam entladen wird. In jedem Falle soll ein gutes, der Abtastfrequenz adäquates Einschwingverhalten erzielt werden.

Die Erfindung löst diese Aufgabe dadurch, daß der Abtastkreis einen aus Bipolar-Transistoren aufgebauten Differenzverstärker enthält, an dessen Ausgang der Kondensator und der Ausgangskreis angeschlossen sind, daß der Ausgangskreis einen aus Bipolar-Transistoren aufgebauten Ausgangsverstärker enthalt, und daß sowohl der Differenzverstärker als auch der Ausgangsverstärker mit Konstantstromquellen verbunden sind, die ebenfalls aus Bipolar-Transistoren aufgebaut sind und die auf das Auftreten der Abtastimpulse hin derart wirksam gesteuert werden, daß die Höhe des durch sie jeweils fließenden Konstantstroms der jeweiligen Abtastimpulsfrequenz proportional ist.

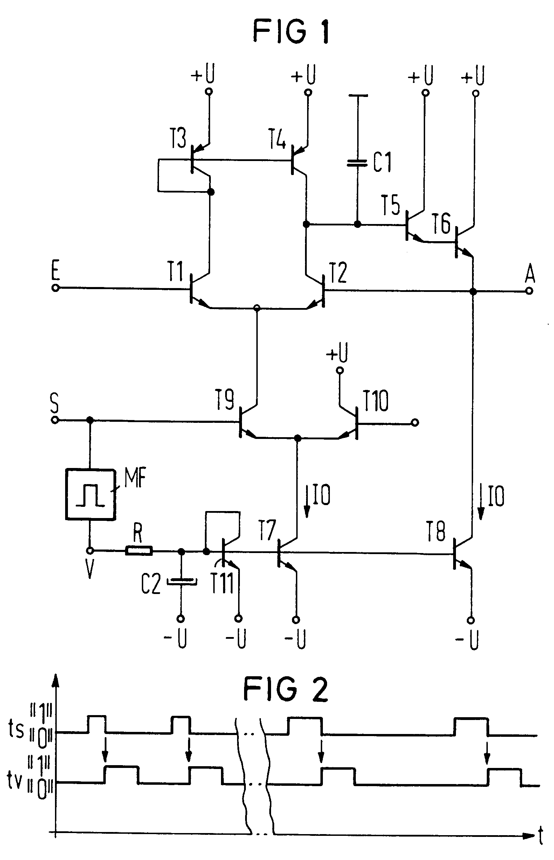

In den Zeichnungen ist ein Ausführungsbeispiel der Erfindung nur in wesentlich zu ihrem Verständnis beitragenden Bestandteilen dargestellt, worauf dieselbe jedoch keineswegs beschränkt ist. Dabei zeigt FIG 1 ein schaltungsmäßiges Ausführungsbeispiel einer erfindungsgemäßen Abtast- und Halteschaltung; FIG 2 zeigt in einem Zeitdiagramm unterschiedliche Impuls-Pausen-Verhältnisse bezüglich auftretender Abtast- und Halte-Impulse.

In FIG 1 bilden die Transistoren T1, T2, T3 und T4 einen Differenzverstärker. Die Transistoren sind Bipolar-Transistoren. An seinem Ausgang ist ein Ladekondensator C1 angeschlossen. Ein ebenfalls an seinen Ausgang angeschlossener Ausgangskreis wird mit Hilfe der Transistoren T5 und T6 gebildet. Diese Transistoren bilden einen Ausgangsverstärker mit einem Ausgangsanschluß A.

Zwischen einem Eingangsanschluß E und dem Ladekondensator C1 befindet sich ein Abtastkreis, der nicht nur aus den Transistoren T1 bis T4 des Differenzverstärkers besteht sondern auch noch aus weiteren Transistoren T7, T9, T10, T11. Durch über eine Klemme S zugeführte Abtastimpulse ist der Kondensator C1 aufladbar, und zwar nach Maßgabe des am Eingangsanschluß E jeweils vorhandenen Eingangssignales. Eine auf dem Kondensator jeweils gespeicherte Signalspannung wird über den Ausgangsanschluß A abgegeben, und zwar mit Hilfe des aus den Transistoren T5, T6 und T8 bestehenden Ausgangskreises, der zwischen dem Ladekondensator C1 und dem Ausgangsanschluß A vorgesehen ist. In diesem Ausgangskreis bilden die Transistoren T5 und T6 den genannten Ausgangsverstärker.

Sowohl der aus den Transistoren T1 bis T4 gebildete Differenzverstärker, als auch der aus den Transistoren T5 und T6 bestehende Ausgangsverstärker sind mit Konstantstromquellen verbunden. Diese sind mit Hilfe der Transistoren T7 und T8 gebildet. Diese Transistoren sind ebenfalls Bipolar-Transistoren. Diese Transistoren werden auf das Auftreten der Abtastimpulse, die über die Klemme S eintreffen, entsprechend der Häufigkeit ihres Auftretens wirksam gesteuert, und zwar in der Weise, daß die Höhe des durch sie jeweils fließenden Konstantstromes der jeweiligen Abtastimpulsfrequenz proportional ist. Hierzu ist vorgesehen, daß die Bipolar-Transistoren T7 und T8, die die genannten Konstantstromquellen bilden, eingangsseitig am Ausgang eines Frequenz-Strom-Wandlers MF angeschlossen sind. Seinem Eingang werden die Abtastimpulse von der Klemme S zugeführt. Der genannte Frequenz-Strom-Wandler ist als ein monostabiles Kippglied realisiert. Dasselbe wird durch die Abtastimpulse (über S eintreffend) getriggert. Mit dem Ausgang dieses monostabilen Kippgliedes ist über einen Widerstand R ein weiterer Kondensator C2 verbunden. Mit ihm wiederum sind die Basisanschlüsse der genannten Bipolar-Transistoren T7 und T8 der Konstantstromquellen verbunden. Ferner ist mit der durch den Bipolar-Transistor T7 gebildeten Konstantstromquelle, die für den genannten Differenzverstärker (Bipolar-Transistoren T1 bis T4) vorgesehen ist, ein weiterer Bipolar-Transistor T9 verbunden, der durch die Abtastimpulse (über S eintreffend) direkt in den leitenden Zustand steuerbar ist. Schließlich ist auch noch der Ausgang des Ausgangsverstärkers, der aus den Bipolar-Transistoren T5 und T6 gebildet ist, mit dem invertierenden Eingang des Differenzverstärkers, der aus den Bipolar Transistoren T1 bis T4 gebildet ist, verbunden.

Das monostabile Kippglied MF löst bei jedem (über S eintreffenden) Abtastimpuls einen Impuls konstanter Breite aus. Dies ist in FIG 2 dargestellt. (Eintreffende Abtastimpulse unterschiedlicher Breite sind in FIG 2 bei ts dargestellt.) Der über das monostabile Kippglied MF jeweils weitergegebene Impuls, der über die Klemme v und den Widerstand R weitergegeben wird, ist jeweils von konstanter Breite. Dies hat zur Folge, daß der Konstantstrom Io, der über den Kollektor des Bipolar-Transistors T7 fließt, genau proportional zur Abtastimpuls-Frequenz ist. Damit ist das angestrebte Ziel erreicht: Die Aufladung des Kondensators C1 erfolgt umso schneller, je größer der Konstantstrom IO ist - und dieser ist wiederum von der Sampling-Rate abhängig; und auch die Entladung des Kondensator C1 über den Basisstrom T5/T6 ist abhängig von IO und damit von der Sampling-Rate. - Bei dem in FIG 2 dargestellten Zeitdiagramm wurde von der Annahme ausgegangen, daß das Impuls-Pausen-Verhältnis der Abtastimpulse immer konstant ist, woraus resultiert, daß der Mittelwert der betreffenden Spannung ebenfalls konstant ist.

## Patentansprüche

1. Abtast- und Halteschaltung mit einem zwischen einem Eingangsanschluß (E) und einem Kondensator (C1) liegenden Abtastkeis (T1, T2, T3, T4, T7, T9, T10, T11), der durch ihm zugeführte Abtastimpulse (ts) den Kondensator (C1) nach Maßgabe eines am Eingangsanschluß (E) jeweils vorhandenen Eingangssignals aufzuladen gestattet,
mit einem Ausgangskreis (T5, T6, T8), der zwischen dem Kondensator (C1) und einem Ausgangsanschluß (A) vorgesehen ist, von welchem ein der auf dem Kondensator (C1) jeweils gespeicherten Signalspannung entsprechendes Ausgangssignal abgebbar ist,
wobei der Abtastkreis einen aus Bipolar-Transistoren aufgebauten Differenzverstärker (T1, T2, T3, T4) enthält, an dessen Ausgang der Kondensator (C1) und der Ausgangskreis (T5, T6) angeschlossen sind,
**dadurch gekennzeichnet**,
daß der Ausgangskreis (T5, T6) einen aus Bipolar-Transistoren (T5, T6) aufgebauten Ausgangsverstärker enthält, und daß sowohl der Differenzverstärker (T1, T2, T3, T4) als auch der Ausgangsverstärker (T5, T6) mit Konstantstromquellen (T7, T8) verbunden sind, die ebenfalls aus Bipolar-Transistoren (T7, T8) aufgebaut sind und die auf das Auftreten der Abtastimpulse (ts) in der Art wirksam gesteuert werden, daß die Höhe des durch sie jeweils fließenden Konstantstroms der jeweiligen Abtastimpulsfrequenz proportional ist.

2. Abtast- und Halteschaltung nach Anspruch 1,
**dadurch gekennzeichnet**,
daß die Bipolar-Transistoren (T7, T8) der Konstantstromquellen eingangsseitig am Ausgang eines Frequenz-Strom-Wandlers angeschlossen sind, dessen Eingang die Abtastimpulse (ts) zugeführt werden.

3. Abtast- und Halteschaltung nach Anspruch 2, **dadurch gekennzeichnet,** daß die Basen der Bipolar-Transistoren (T7, T8) der Konstantstromquellen mit einem weiteren Kondensator (C2) verbunden sind, der mit dem Ausgang eines durch die Abtastimpulse triggerbaren monostabilen Kippgliedes (MF) verbunden ist.

4. Abtast- und Halteschaltung nach einem der Ansprüche 1 bis 3, **dadurch gekennzeichnet,** daß mit der Konstantstromquelle (T7) für den Differenzverstärker (T1, T2, T3, T4) ein weiterer Bipolar-Transistor (T9) verbunden ist, der durch die Abtastimpulse (Ts) direkt in den leitenden Zustand steuerbar ist.

5. Abtast- und Halteschaltung nach einem der Ansprüche 1 bis 4, **dadurch gekennzeichnet,** daß der Ausgang des Ausgangsverstärkers (T5, T6) mit dem invertierenden Eingang des Differenzverstärkers (T1, T2, T3, T4) verbunden ist.

## Claims

1. Sample and hold circuit having a sampling circuit (T1, T2, T3, T4, T7, T9, T10, T11), which is situated between an input terminal (E) and a capacitor (C1) and by means of sampling pulses (ts) fed to it permits the capacitor (C1) to be recharged in accordance with an input signal respectively present at the input terminal (E), having an output circuit (T5, T6, T8) which is provided between the capacitor (C1) and the output terminal (A) and which can output an output signal corresponding to the signal voltage respectively stored on the capacitor (C1), the sampling circuit containing a differential amplifier (T1, T2, T3, T4) assembled from bipolar transistors and to whose output the capacitor (C1) and the output circuit (T5, T6) are connected characterized in that the output circuit (T5, T6) contains an output amplifier assembled from bipolar transistors (T5, T6), and in that both the differential amplifier (T1, T2, T3, T4) and the output amplifier (T5, T6) are connected to constant current sources (T7, T8) which are likewise assembled from bipolar transistors (T7, T8) and are effectively controlled with respect to the occurrence of the sampling pulses (ts) in such a way that the level of the constant current respectively flowing through them is proportional to the respective sampling pulse frequency.

2. Sample and hold circuit according to Claim 1, characterized in that the bipolar transistors (T7, T8) of the constant current sources are connected on the input side to the output of a frequency/current converter to whose input the sampling pulses (ts) are fed.

3. Sample and hold circuit according to Claim 2, characterized in that the bases of the bipolar transistors (T7, T8) of the constant current sources are connected to a further capacitor (C2) which is connected to the output of a monostable multivibrator (MF) which can be triggered by the sampling pulses.

4. Sample and hold circuit according to one of Claims 1 to 3, characterized in that a further bipolar transistor (T9) which can be switched on directly by the sampling pulses (Ts) is connected to the constant current source (T7) for the differential amplifier (T1, T2, T3, T4).

5. Sample and hold circuit according to one of Claims 1 to 4, characterized in that the output of the output amplifier (T5, T6) is connected to the inverting input of the differential amplifier (T1, T2, T3, T4).

## Revendications

1. Circuit d'échantillonnage et de maintien comportant
un circuit d'échantillonnage (T1, T2, T3, T4, T7, T9, T10, T11) qui est monté entre une borne d'entrée (E) et un condensateur (C1) et qui est agencé de manière à charger, par l'intermédiaire d'impulsions d'échantillonnage (ts) qui lui sont envoyées, le condensateur (C1) en fonction d'un signal d'entrée présent à la borne d'entrée (E),
et un circuit de sortie (T5, T6, T8), qui est prévu entre le condensateur (C1) et une borne de sortie (A) et qui est susceptible de fournir un signal de sortie correspondant à la tension de signal accumulée dans le condensateur (C1),
du type dans lequel le circuit d'échantillonnage comporte un amplificateur différentiel (T1, T2, T3, T4) qui est agencé à partir de transistors bipolaires, et à la sortie duquel sont reliés le condensateur (C1) et le circuit de sortie (T5, T6), caractérisé par le fait :
que le circuit de sortie (T5, T6) comporte un amplificateur de sortie agencé à partir de transistors bipolaires (T5, T6), et qu'aussi bien l'amplificateur différentiel (T1, T2, T3, T4) qu'également l'amplificateur de sortie (T5, T6) sont reliés à des sources de courant constant (T7, T8) qui sont également agencées à partir de transistors bipolaires (T7, T8) et qui sont commandées de manière active sur l'apparition des impulsions d'échantillonnage (ts), en sorte que le niveau du courant constant circulant dans ces transistors est proportionnel à la fréquence des impulsions d'échantillonnage respective.

2. Circuit d'échantillonnage et de maintien suivant la revendication 1, caractérisé en ce que les transistors bipolaires (T7, T8) des sources de courant constant sont reliés, côté entrée, à la sortie d'un transducteur fréquence-courant, à l'entrée duquel sont envoyées les impulsions d'échantillonnage (ts).

3. Circuit d'échantillonnage et de maintien suivant la revendication 2, caractérisé en ce que les bases des transistors bipolaires (T7, T8) des sources de courant constant sont reliées à un second condensateur (C2), qui est relié à la sortie d'un circuit à bascule (MF) monostable déclenchable par les impulsions d'échantillonnage.

4. Circuit d'échantillonnage et de maintien suivant l'une des revendications 1 à 3 caractérisé en ce qu'un transistor bipolaire supplémentaire (T9), qui est susceptible d'être commandé par les impulsions d'échantillonnage (Ts) directement à l'état conducteur, est relié à la source de courant constant (T7) pour l'amplificateur différentiel (T1, T2, T3, T4).

5. Circuit d'échantillonnage et de maintien suivant l'une des revendications 1 à 4, caractérisé en ce que la sortie de l'amplificateur de sortie (T5, T6) est reliée à l'entrée inverseuse de l'amplificateur différentiel (T1, T2, T3,T4).
